(19) Europäisches Patentamt
European Patent Office
Office européen des brevets

(11) **EP 4 753 201 A1**

(12) **EUROPEAN PATENT APPLICATION**

(43) Date of publication:
03.06.2026 Bulletin 2026/23

(21) Application number: 24216086.9

(22) Date of filing: 28.11.2024

(51) International Patent Classification (IPC):
H04L 7/00 $^{(2006.01)}$    H04L 7/033 $^{(2006.01)}$
H04L 25/03 $^{(2006.01)}$

(52) Cooperative Patent Classification (CPC):
H04L 7/0062; H04L 7/0334; H04L 25/0212;
H04L 25/03006; H04L 25/4917

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: NXP B.V.
5656 AG Eindhoven (NL)

(72) Inventors:
• Tanc, Ahmet Korhan
  5656 AG Eindhoven (NL)
• Kroekenstoel, Dave Sebastiaan
  5656 AG Eindhoven (NL)

(74) Representative: Schmütz, Christian Klaus
Johannes
NXP Semiconductors Germany GmbH
Intellectual Property Group
Beiersdorfstr. 12
22529 Hamburg (DE)

(54) **A RECEIVER**

(57)    A receiver for a wireline channel communication system, comprising an input for receiving a signal from one or more wires and an analog to digital configured to output a digital representation of the analog signal. A slicer module configured output a digital logic signal based on an amplitude of the analog signal. A high pass filter configured to receive the digital representation of the analog signal and output a filtered signal. A phase detector configured to receive a first signal based on the digital logic signal, and the filtered signal and configured to output an error signal indicative of a phase difference between the first signal and the filtered signal. A clock data recovery module configured to output a clock adjustment signal based on the error signal, wherein the clock adjustment signal is configured to control a sampling performed by the ADC.

Figure 1

**Description**

Field

The present disclosure relates to a receiver. In particular, it relates to a receiver for a wireline channel communication system. It also relates to a method for controlling said receiver and to an electronic device comprising said receiver.

Background

Communication systems require channel coding and equalization to optimise the quality of a received signal. To improve the quality of the received signals, it is important to ensure good clock data recovery (CDR) so that data is sampled accurately and consistently even when there are variations in the timing of the incoming signal. Ensuring effective CDR for wireline channel communication systems is challenging due to distortion of the incoming signal, which can lead to reduced performance.

Summary

According to a first aspect of the present disclosure there is provided a receiver for a wireline channel communication system, comprising:

an input for receiving a signal from one or more wires;
an analog to digital converter, ADC, configured to receive an analog signal from said input and configured to output a digital representation of the analog signal;
a slicer module configured to receive the digital representation of the analog signal and configured to output a digital logic signal based on an amplitude of the analog signal;
a high pass filter, HPF, configured to receive the digital representation of the analog signal and output a filtered signal;
a phase detector configured to receive a first signal based on the digital logic signal, and the filtered signal, wherein the phase detector is further configured to output an error signal indicative of a phase difference between the first signal and the filtered signal; and
a clock data recovery, CDR, module configured to output a clock adjustment signal based on the error signal, wherein the clock adjustment signal is configured to control a sampling performed by the ADC.

In one or more examples, the sampling performed by the ADC may be controlled by adjusting, based on the clock adjustment signal, one or more of:

a phase of a clock signal provided to the ADC, and
a frequency of a clock signal provided to the ADC.

In one or more examples, the clock adjustment signal may be configured to adjust the sampling rate of the ADC.
In one or more examples, the clock adjustment signal may be configured to adjust parameters of a clock signal provided to ADC, wherein the parameters of the clock signal may be controllable by adjusting one or more of:

the phase of the clock signal, and
the frequency of the clock signal.

In one or more embodiments, the receiver for a wireline channel communication system further comprises a Signal to Noise, SNR, estimator, wherein the SNR estimator is configured to determine a Signal to Noise Ratio based on the digital logic signal, and wherein the HPF is a tuneable HPF, wherein a cut off frequency of the tuneable HPF is based on a control signal, wherein the control signal is based on an output of the SNR estimator.
In particular, in one or more examples the SNR estimator is configured to determine the Signal to Noise Ratio based on a difference between the digital representation of the analog signal and the digital logic signal, which may comprise a difference between the input and output of the slicer module.
In one or more embodiments, the receiver for a wireline channel communication system further comprises an equalizer module coupled between the ADC and the slicer module, wherein the equalizer module is configured to one or more of amplify and/or attenuate specific frequency components of the digital representation of the analog signal to make the amplitude of the digital representation of the analog signal more uniform across a bandwidth of the digital representation of the analog signal.

In one or more embodiments, the slicer module is configured to compare the digital representation of the analog signal to one or more predefined thresholds and is configured to determine the digital logic signal based on the comparison.

In one or more embodiments, the phase detector comprises a Mueller-Muller phase detector.

In one or more embodiments, the input for receiving the signal from one or more wires is configured to receive the signal from a twisted pair cable.

In one or more embodiments, the tuneable HPF is provided by an Infinite Impulse Response filter.

In one or more examples, the tuneable filter is provided by a Finite Impulse Response filter.

In one or more embodiments, the tuneable HPF is a first-order HPF.

In one or more embodiments, the tuneable HPF is a higher-order HPF.

In one or more embodiments, based on the error signal, the clock adjustment signal is configured to one of

increase a time shift applied to sampling performed by the ADC in response to an increase in the error signal, or decrease a time shift applied to sampling performed by the ADC in response to a decrease in the error signal.

According to a second aspect of the present disclosure, there is provided method for controlling a receiver for a wireline channel communication system comprising:

an input for receiving a signal from one or more wires, an analog to digital converter, ADC, a slicer module, a HPF, a phase detector and a clock data recovery, CDR, module; the method comprising receiving, by the ADC an analog signal; converting the analog signal to a digital representation of the analog signal; assigning, by the slicer module, digital logic values to the digital representation of the analog signal based on an amplitude of the analog signal to form a digital logic signal; filtering, by the HPF, the digital representation of the analog signal to generate a filtered signal; determining, by the phase detector an error signal based on the difference between the digital logic signal and the filtered signal; and determining by the CDR module a clock adjustment signal configured to control a sampling performed by the ADC.

In one or more embodiments the method further comprises,

estimating a Signal to Noise Ratio based on the digital logic signal; generating a control signal based on the estimated SNR; and tuning a cut-off frequency of the HPF based on the control signal.

In one or more embodiments the method further comprises,

incrementing the cut off frequency of the HPF; determining the estimated SNR; comparing the estimated SNR to an estimated SNR for a previous cut off frequency of the HPF; wherein based on the comparison being indicative of the estimated SNR not increasing:

decrementing the cut off frequency of the HPF to the previous value of the cut off frequency; and setting the receiver to use the decreased value of the cut off frequency as an optimised cut off frequency for further communication with the transmitter.

In one or more embodiments the method further comprises,
equalizing the digital representation of the analog signal prior to performing the step of assigning, by the slicer module, of the digital logic values.

In one or more embodiments the method further comprises,
assigning by the slicer module, the digital logic values to the digital representation of the analog signal based on an amplitude of the analog signal to form the digital logic signal comprises:

comparing, by the slicer module, the digital representation of the analog signal to one or more predefined thresholds; and determining the digital logic signal based on said comparison.

According to a third aspect of the present disclosure, there is provided an electronic device including the receiver of the first aspect.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

Brief Description of the Drawings

One or more embodiments will now be described by way of example only with reference to the accompanying drawings in which:

Figure 1 shows an example embodiment of a wireline channel communication system;

Figure 2 shows an example method of operating the receiver of the wireline channel communication system figure 1; and

Figure 3 shows an electronic device comprising the receiver of the wireline channel communication system of figure 1.

Figure 4 shows an example process for optimizing the receiver of the wireline channel communication system of figure 1.

Detailed Description

The examples of the present disclosure relate to a wireline channel communication system and in particular to a receiver of the wireline channel communication system. The receiver is configured to account and compensate for the group delays introduced for varying frequency components of the signal caused by e.g. the skin effect on the wireline channel of the communication system.

The present disclosure specifically relates to obtaining an accurate clock data recovery (CDR) for wireline channel communication systems. The receiver of the embodiments has particular application where the wireline channel is provided by twisted pair cables, which have been found to experience group delay distortion due to the skin effect. In such cases, the effect of the group delay is related to the frequency of the signal being transmitted through said twisted pair cables. It will however be appreciated that the wireline channel may not be limited to a twisted pair cable arrangement and the receiver may be communicatively coupled by other cable arrangements to a transmitter.

Typically, CDR can be achieved using a conventional Mueller-Muller (MM) phase detection approach. In particular MM CDR may use a baud-rate CDR correlating the input and the output of receiver. Although such a baud-rate CDR can be effective, its performance relies on the symmetry of the channel impulse response. Furthermore, this approach of using a conventional MM phase detection approach can result in a bias in the timing estimation. Hence the signal-to-noise ratio (SNR) can degrade in such typical approaches and therefore such known approaches are not ideal. There are many CDR techniques as will be known to the skilled person, and these will not be described here. Many known CDR techniques rely on the symmetry of the channel impulse response and therefore only operate effectively on signals which have a constant group delay over the transmission bandwidth.

The present embodiments describe a receiver 101 for a wireline channel communication system in which the received analog signal is converted to a digital signal and filtered to reduce or negate the effect of the group delay distortion. This has been found to provide a more reliable CDR across the whole bandwidth of interest.

The embodiments described herein have been found to provide for effective CDR, that can allow for improved sampling of the received signals.

It has been found that by providing effective CDR, while the post-sampling SNR may increase, the power of the inter-symbol interference (ISI) terms after sampling can be significantly reduced and therefore can allow for a more reliable signal to be extracted at the receiver. This can make subsequent processing stages more efficient.

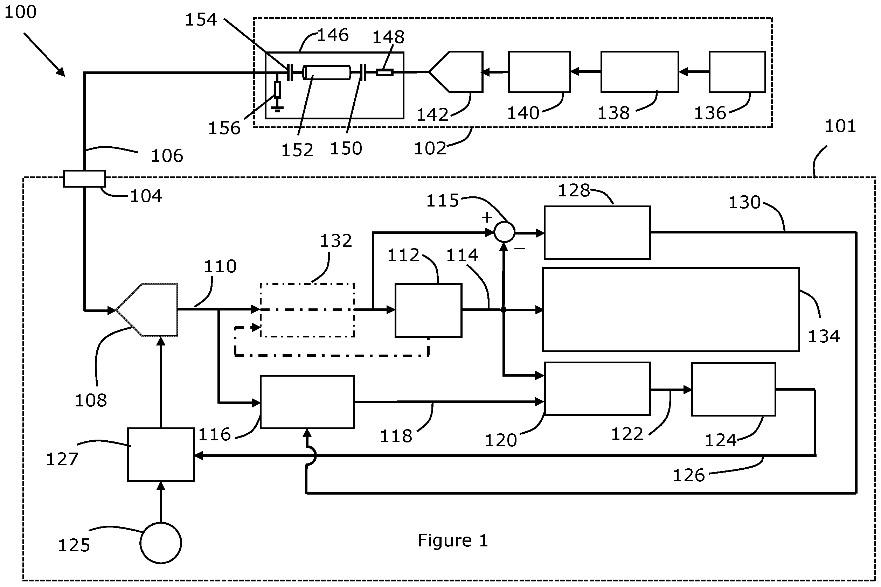

Figure 1 shows an example embodiment of a wireline channel communication system 100 comprising a receiver 101 and a transmitter/wireline channel 102 of the wireline channel communication system 100. The receiver 101 comprises an input 104 for receiving a signal from one or more wires 106, such as a twisted pair cable. The receiver further includes an analog to digital converter (ADC) 108, a slicer module 112, a high pass filter (HPF) 116, a phase detector 120, a clock data recovery (CDR) module 124 and also a clock 125 for the ADC 108 and a clock adjustment module 127.

These components and their operation will be described below after introducing the other components of the present example receiver 101. Figure 1 also shows a demodulator 134 configured to demodulate the signal received by the receiver 101 for further processing.

It will be appreciated that the transmitter/wireline channel 102 of the wireline channel communication system 100 is not the main focus of this disclosure but is included for completeness.

The transmitter of the wireline channel communication system 100 comprises a bit stream source 136, a modulator 138, a pulse shaping component 140, a digital to analog converter (DAC) 142 and a wireline channel, which is shown schematically in box 146. It will be appreciated that in other examples a different configuration for the transmitter 102 may be implemented in a manner known to the person skilled in the art.

In the present example, the modulator 138 and the demodulator 134 may operate based on PAM2 modulation scheme, but alternatively could module/demodulate with a PAM4 or other PAM modulation scheme.

In some examples, the wireline channel 146 may include driving/loading resistors 148, 156, coupling capacitors 150, 154 and a twisted pair cable 152. In some specific examples the driving/loading resistors 148, 156 may be 100 Ohm resistors and the coupling capacitors 150, 154 may be 50 nF capacitors, all are single-ended equivalent. It will be appreciated that these specific circuit component values may differ in other implementations.

A very brief summary of the operation of the transmitter 102 of the wireline channel communication systems 100 is provided here for context. In one or more examples, the bit stream source 136 may be a binary source that generates equiprobable bits, such as at a rate of 5.625 GHz (e.g. as in 10GBASET1). The modulator 138 may be a Pulse Amplitude Modulator (PAM) which operates in a PAM2 mode. Following the modulation, the resulting signal is shaped. In some examples the signal may be shaped using a raised cosine filter with a half roll-off to shape the modulated symbols provided by the modulator 138. The digital-to-analog converter (DAC) 142 then converts the digital signal to an analog signal and feeds it to the wireline channel 146 for transmission to the receiver 101 of the wireline channel communication system 100.

A mathematical analysis of the wireline channel communication systems 100 will now be provided for an arrangement wherein the characteristic impedance of the twisted pair cable 152 of the wireline channel 146 is 100 Ohm. The impulse response $h(t)$ of the wireline channel 146 can be approximated as:

$$h(t) \approx \frac{1}{4\pi} \int_{-\infty}^{+\infty} e^{-\alpha x} e^{j(\omega t - \beta l)} d\omega, \quad (1)$$

In the above expression, $\alpha$ is an attenuation constant, $\beta$ is a phase constant, and $l$ is the length of the twisted pair cable 152 in meters. For an RLC transmission line model, it can be stated that:

$$\beta = Im\{\sqrt{(R + j\omega L)(j\omega C)}\}, \quad (2)$$

where $Im$ denotes the imaginary part of the expression. For a twisted pair cable, $\beta$ is not constant since both the resistance ($R$) and inductance ($L$) of the twisted pair cable vary with the frequency of the signal therethrough due to the skin effect. In such a case, the resistance and inductance may be determined using:

$$R = c_1 \sqrt{\omega} \quad (3.1),$$

and

$$L = L_{int} + L_{ext} = \frac{c_2}{\sqrt{\omega}} + c_3, \quad (3.2)$$

In equation 3.2, $L$ is the summation of internal ($L_{int}$) inductance and external ($L_{ext}$) inductance. Also, $c_1 \approx c_2$, and $c_3$ are the cable-specific constants, respectively. At lower frequencies, $L_{int}$ becomes dominant, and the phase linearity (with the frequency) is disturbed significantly.

As will be known to the skilled person, a sampling instant of the ADC is the moment when the analog signal is sampled by the ADC and the sampling rate is the frequency at which the ADC takes consecutive samples of the analog signal. It will be appreciated that the sampling instant may be adjusted by a phase shift applied to the sampling frequency (or clock/clock signal from which the sampling frequency is derived) for one or more samples taken by the ADC. The Mueller-Muller (MM) time recovery approach optimizes the sampling instant of the ADC as:

$$t_{MM} = \underset{t}{\mathrm{argmin}} \; |h(t + T_s) - h(t - T_s)|, \qquad (4)$$

where $T_s$ is the symbol duration and |.| is the absolute value operator. However, under the assumption of perfect inter-symbol interference (ISI) cancellation in the signal path, the optimum timing that maximizes the signal-to-noise ratio (SNR) is given by:

$$t_{opt} = \underset{t}{\mathrm{argmax}} \; |h(t)|. \qquad (5)$$

From the above, it is clear that when the impulse response h(t) is symmetric around its peak value, the MM time recovery gives the optimum timing. However, it has been realized that the symmetry of the impulse response h(t) can be disturbed due to the distortion in the transmission line group delay as described above. Hence, there may be a bias in the MM timing that would cause a SNR degradation using the above approach.

In one or more examples, the bias in the MM time recovery caused by the skin effect according to the above approach can be removed. The examples described herein rely on high pass filtering of the output of the ADC supplied to the phase detector 120. In some examples this can be achieved by using a first-order HPF with a transfer function:

$$G(z) = \frac{b - bz^{-1}}{1 - az^{-1}}, \qquad (6.1)$$

$$a = \frac{1 - \tau}{1 + \tau}, \qquad b = \frac{1}{1 + \tau}, \qquad \tau = \frac{\pi f_c}{f_s}. \qquad (6.2)$$

In the above example the HPF 116 is implemented as a tuneable high pass filter and $f_c$ is the cut-off frequency of the tuneable HPF. In the above expression $f_s$ is the sampling frequency of the ADC 108. In the present embodiment the transfer function (as described by expression 6.1) is controlled by tuning the cut-off frequency $f_c$ of the HPF 116.

In other examples, the sampling frequency $f_s$ of the ADC 108 may be adjusted instead of/or in addition to tuning the cut-off frequency $f_c$ of the HPF 116 to control the transfer function.

Considering expressions 6.1 and 6.2 it will be appreciated that in some examples, the transfer function of the HPF may also be controlled by a single parameter ($\tau$) that is a function of the cut-off frequency of the HPF 116 and the sampling frequency of the ADC 108.

In the present embodiment the low-frequency distortion caused by the increase in the skin depth is reduced by increasing the cut-off frequency of the HPF. In other examples the low-frequency distortion may be reduced by reducing the sampling frequency of the ADC 108 instead of, or in addition to, increasing the cut-off frequency of the HPF 116. However, very high values of $\tau$ may cause an extra bias in the timing estimation. Therefore, the selection of $\tau$ or more particularly in this embodiment, selecting the cut-off frequency of the HPF 116, involves a trade-off between compensating for the skin effect and creating this extra bias.

Returning to figure 1, the analog to digital converter 108 is configured to receive an analog signal from the input 104 and is configured to output a digital representation of the analog signal 110. In some examples, the ADC 108 may receive a clock signal from the clock 125. The clock signal may be adjusted in terms of its frequency and/or phase before being received by the ADC 108. The clock signal may be adjusted by a clock adjustment module 127 configured to receive a clock adjustment signal 126 (from the CDR module 124) and the clock signal from the clock 125. In such an example the clock adjustment module 127 may be configured to apply a phase shift to the clock signal from the clock 125 to provide a phase offset compensation between the transmitter 102 and the receiver 102. Additionally or alternatively, the clock adjustment module 127 may be configured to control the frequency of the clock signal from the clock 125 to provide a frequency offset compensation between the transmitter 102 and the receiver 102. It will be appreciated that the receiver 101 may receive the clock signal from an external source.

In some other examples the output of the CDR module 124 may directly control the sampling performed by the ADC 108 without the need for the clock 125 or the dedicated clock adjustment module 127.

In the present embodiment, controlling the sampling performed by the ADC 108 includes adjusting the phase of the sampling points such that the moment when the analog signal is sampled (i.e. the sampling instant) by the ADC can be controlled. Such sampling points are adjusted based on the clock adjustment signal 126. In particular, the phase of the clock 125 supplied to the ADC 108 is adjusted based on the clock adjustment signal 126 to control the sampling instants of the ADC to provide said phase offset compensation. In other examples, the clock adjustment signal is provided directly to the ADC 108 and includes the necessary timing information to control said sampling.

In the present embodiment, it is assumed that there is no frequency offset between the transmitter 102 output and the receiver 101 input (e.g. in this example, there is no frequency difference between a clock of the transmitter 102 and a clock of the receiver 101). Hence, in the present embodiment, the CDR module 124 is configured to perform a phase correction to the clock signal provided to the ADC 108.

However, in other examples, there may be a frequency difference between the transmitter 102 output frequency and the receiver 101 input frequency (i.e. there is a frequency difference between the clock of the transmitter 102 and the clock of the receiver 101). In such an example, the CDR module 124 may alternatively or additionally be configured to compensate for the frequency difference. In some examples, the frequency offset is compensated for by controlling the sampling rate $f_s$ of the ADC 108 based on the clock adjustment signal 126.

The slicer module 112 of the receiver 101 is configured to receive the digital representation of the analog signal 110 and is configured to output a digital logic signal 114 based on an amplitude of the analog signal. In the present embodiment, the slicer module 112 is configured to output a two-level digital signal. In some other examples, the slicer module 112 may be configured to assign digital logic values to the digital representation of the analog signal 110 based on an amplitude of the analog signal to form the digital logic signal 114 which has more than two levels. The slicer module 112 provides the function of a digital data slicer as will be familiar to those skilled in the art.

It will be appreciated that in some examples, the slicer module 112 may be configured to compare the digital representation of the analog signal 110 to one or more reference values to determine the state of the digital logic signal 114 for a corresponding portion of the digital representation of the analog signal 110. The digital logic signal 114 output by the slicer module 112 may be a binary signal, such as the two-level digital signal. In other examples the digital logic signal 114 may be a multi-level logic signal determined by comparing the digital representation of the analog signal 110 to a plurality of reference/threshold voltages, such as a three-level or four-level logic signal. In the present embodiment the digital logic signal 114 is a binary PAM signal.

The receiver 101 shown in figure 1 includes a Signal to Noise (SNR) estimator 128, wherein the SNR estimator 128 is configured to receive a difference between the input and output of the slicer module 112. In some examples, the input to the SNR estimator may be provided by a difference element 115 that is configured to receive the digital representation of the analog signal 110 from the ADC 108 at a first input and the digital logic signal 114 from the slicer module 112 at a second input. The difference element may be configured to output the difference between its first and second input to the SNR estimator 128. In some other examples, the input to the SNR estimator 128 may be considered as the error between the digital representation of the analog signal 110 from the ADC 108 and the digital logic signal 114 from the slicer module 112 and may be referred to as a slicer error.

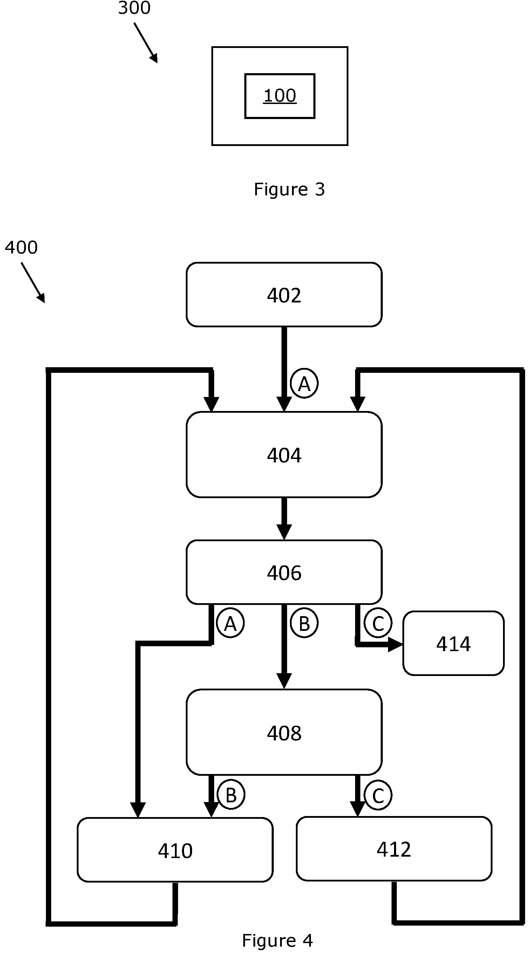

In the present embodiment, the SNR estimator 128 provides an output 130 indicative of the estimate of the SNR of the digital logic signal 114. In some examples the output 130 of the SNR estimator 128 or a signal derived therefrom may be provided to the HPF 116 as a control signal to control the cut-off frequency $f_c$ of the HPF 116. The cut-off frequency of the HPF 116 may be optimized according to the output of the SNR estimator 128. In some examples the optimization of the cut-off frequency of the HPF 116 may be achieved using a brute-force approach or an iterative approach. The iterative optimization approach will be described later with respect to figure 4.

In some other examples, it may be possible to include a (low pass) filter after the SNR estimator 128 to filter the output 130 of the SNR estimator 128. This may lead to a more stable operation of the receiver 101. For instance, after the estimated SNR settles, the cut-off frequency can remain fairly constant and is only adjusted when the wireline channel 146 experiences changes over time due to e.g. temperature variations or moving/bending cables. In some other examples, the SNR estimator 128 may have a measurement window which smooths the output 130 of the SNR estimator 128, such as by the use of the low pass filter.

The following examples will describe the operation of an embodiment of wireline channel communication system 100 in which the HPF 116 of the receiver 101 is a tuneable HPF 116. In such an example the tuneable HPF 116 is also configured to receive the output of the ADC 108 and is configured to output a filtered signal 118, i.e. a high pass filtered digital signal. As described above, the tuneable filter has a cut off frequency $f_c$.

The use of the HPF 116, which in some but not all embodiments has a tuneable cut-off frequency, has been found to be advantageous.

In some examples, the tuneable HPF 116 may be implemented as an Infinite Impulse Response (IIR) filter. In other examples the tuneable HPF may be provided by a Finite Impulse Response (FIR) filter. In some other examples the tuneable HPF 116 may be a first-order HPF. It will be appreciated that other order HPFs may also be used.

The phase detector 120 is configured to receive a first signal based on the digital logic signal 114 and a second signal based on the filtered signal 118. In some examples the phase detector 120 is further configured to output an error signal 122 indicative of a phase difference between the first signal and the filtered signal. In some examples the phase detector 120 may be a Mueller-Muller (MM) phase detector. In such an example the action of the MM phase detector can be represented as determination of the error signal 122 as expressed by:

$$e(n) = y(n - \Delta)x(n - 1) - y(n - \Delta - 1)x(n), \qquad (7)$$

In the above expression $c(n)$ represents the error signal 122, $y(n)$ is the output of the ADC 108. In the present example, however, $y(n)$ is the high pass filtered output of the ADC 108. $x(n)$ is the signal based on the digital logic signal 114. In the above expression, $\Delta$ is the decision delay of the receiver 101. In some examples the error signal 122 is used to generate a clock adjustment signal 126. In the present example the clock adjustment signal 126 is a phase adjustment signal wherein the phase of the clock 125 supplied to the ADC 108 is adjusted based on the clock adjustment signal 126. In such an example, the output of clock 125 may be adjusted via the clock adjustment module 127. In the present embodiment, the clock adjustment module 127 is a phase shifter configured to adjust the phase of the output of clock 125 based on the clock adjustment signal 126. In other examples the clock adjustment module 127 may be a frequency shifter configured to adjust the frequency of the output of clock 125 based on the clock adjustment signal 126.

Figure 1 shows an example in which the clock data recovery (CDR) module 124 is configured to output the clock adjustment signal 126 based on the error signal 122, wherein the clock adjustment signal 126 is configured to control the sampling performed by the ADC 108. In some examples, based on the error signal 122, the clock adjustment signal 126 may be configured to one of: increase or decrease the phase offset for the clock 125 provided to the ADC 108 to compensate for the phase offset between the transmitter 102 and the receiver 101 to improve the SNR estimator output 130. In some examples, based on an increase in the error signal, the clock adjustment signal 126 may be configured to increase the phase offset of the sampling performed by the ADC 108. In other examples, based on a decrease in the error signal, the clock adjustment signal 126 may be configured to decrease the phase offset of the sampling performed by the ADC 108. In other examples when the error is zero (or sufficiently small) the phase offset of the ADC is not changed. In some examples, the phase shifter (i.e. clock adjustment module 127) has a finite resolution. As such, the adjustment to the phase offset of the sampling performed by the ADC 108 when the error signal 122 is small may be rounded to zero based on the resolution of the phase shifter.

Following on from the example above, the clock adjustment signal 126 may be determined by the following expression:

$$c(n) = \lambda c(n - 1) + (1 - \lambda)\mu e(n). \qquad (8)$$

In the above expression $c(n)$ is the clock adjustment signal 126, $\lambda$ is an integrating parameter, and $\mu$ is an adaptation gain for the ADC 108 and $e(n)$ is the error signal 122. In the above expression, the clock adjustment signal 126 is configured to adjust the phase of the output of clock 125 provided to the ADC 108. In the present embodiment, the sampling performed by the ADC 108 is adjusted according to the clock adjustment signal 126. The unit of $c(n)$ is radians, and the increment/decrement in the phase offset of the ADC is controlled by $c(n)$. When $c(n) = 0$, the phase offset and therefore the sampling performed by the ADC 108 remains unchanged at sampling instant $n$, i.e., the phase offset at sampling instants $n - 1$ and $n$ are the same.

In some applications a sigma-delta modulator (not shown) may be used to refine the clock adjustment signal 126. In some applications a PLL or a phase interpolator or another technique may be used as the clock adjustment module 127 when configured as a phase shifter.

The receiver 101 shown in figure 1 includes an optional equalizer module 132 shown as a dashed box in figure 1. The equalizer module 132 can be coupled between the ADC 108 and the slicer module 112. In some examples, the equalizer module 132 may be configured to one or more of amplify and/or attenuate specific frequency components of the digital representation of the analog signal 110. That is, the output of the ADC 110 can be adjusted to make the amplitude of the digital representation of the analog signal 110 more uniform across a larger bandwidth of the digital representation of the analog signal 110. It will be appreciated that making the digital representation of the analog signal 110 more uniform in terms of its amplitude across the bandwidth may enable the slicer module 112 with an improved input to more accurately determine the values for the digital PAM signal 114. In some examples, the equalizer module 132 may receive as an input both the output of the ADC 110 and the output of the slicer module 112.

The embodiment described above may be modelled as described below. We will consider the complete wireline communication system 100 as shown in figure 1 and assume that the ADC 108 has infinite effective number of bits (ENOB) and followed by a perfect equalizer. In such an example, the output of the slicer module 112 would accurately represent the output of the analog signal received from the modulator 138.

Considering the above arrangement, the clock adjustment signal 126 (e.g. $c(n)$) for this ideal case can be determined using the following parameters in expression 8: $\mu = \pi/1280$ and $\lambda = 0.99$.

In some simulated experiments, $10^6$ samples were generated, and the resulting converged timing values are shown in table 1 below. In such simulated experiments, the conventional MM timing error is more than $0.1T_s$ (where $T_s$ is the symbol duration). However, using the receiver 101 with $\tau = \pi/32$, the timing error is reduced to less than $0.02T_s$. It will be appreciated that the simulated experiments are provided to show just one example of the potential improvement that can be attained and is not intended to be limiting.

Table 1, Timing for Ideal and MM CDRs (in terms of $T_s$). $f_s$ = 5.625 GHz.

| Cable type | 15m of AWG 22 | 15m of AWG 24 |
|---|---|---|
| Optimum timing | 407.33 | 403.50 |
| Convention MM timing | 407.47 | 403.64 |
| Proposed Scheme $\tau = \pi/64$ | 407.39 | 403.57 |
| Proposed Scheme $\tau = \pi/48$ | 407.37 | 403.54 |
| Proposed Scheme $\tau = \pi/32$ | 407.33 | 403.51 |
| Proposed Scheme $\tau = \pi/24$ | 407.30 | 403.47 |
| Proposed Scheme $\tau = \pi/16$ | 407.24 | 403.41 |

The example of table 1, shows that in principle the proposed embodiments can provide improved group delay response, at least for an ideal case with an ADC 108 with perfect equalization and infinite effective number of bits (ENOB).

Thus, as $\tau = \pi f_c/f_s$, it will be appreciated that the cut-off frequency of the tuneable HPF 116, $f_c$, may be controlled to provide an advantageous receiver 101. It will also be appreciated that in other examples the sampling rate $f_s$ may be controlled instead of or in addition to the cut-off frequency $f_c$, to provide said advantageous receiver 101.

In some examples, the equalizer module 132 may be a decision feedback equalizer (DFE) and may have three forward and six backward taps. It will be appreciated that in some examples the equalizer module 132 may have more or less taps. The number of taps in some examples may allow for improved control over the amplitude of the output of the equalizer module 132 and can allow for improved compensation for channel distortions in the digital representation of the analog signal 110.

Table 1 shows the effect of tuning the HPF 116. Actual results using an ADC 108 with finite ENOB, an equalizer module 132, and using a practical optimization algorithm as outlined in figure 4 (described later) for optimizing the cut-off frequency of the HPF are shown below in table 2.

In obtaining the example results below, the equalizer module 132 is initially set to use an adaptation parameter of 0.01 and the equalizer module 132 coefficients are set to zero except for the last forward tap, which, in this specific example is set to five (under the assumption that ADC output is 1V peak-to-peak).

In such an example, the receiver 101 is run for the first $10^6$ samples. Then, the cut-off frequency of the HPF is modified for the next $2 \times 10^5$ samples. If an improvement on the SNR is detected, the cut-off frequency of the HPF is further adjusted until no further improvement in the SNR is detected. The results of this example set of experiments is shown in table 2 below.

Table 2. SNR in dB for the self-tuning of the Proposed Scheme. $f_s$ = 5.625 GHz.

| INTERVAL-($\times$ $10^6$ SAMPLES) | 0.0 to 1.0 | 1.0 to 1.2 | 1.2 to 1.4 | 1.4 to 1.6 | 1.6 to 1.8 |
|---|---|---|---|---|---|
| $\tau$ | 0 | $\pi/64$ | $\pi/48$ | $\pi/32$ | $\pi/24$ |
| 15 m of AWG 22 6-bit ENOB | 20.2 | 22.0 | 22.4 | 22.5 | 22.3 |
| 15 m of AWG 22 5-bit ENOB | 19.4 | 21.0 | 21.3 | 21.4 | 21.3 |
| 15 m of AWG 24 6-bit ENOB | 18.7 | 20.7 | 21.1 | 21.2 | 21.1 |
| 15 m of AWG 24 5-bit ENOB | 18.0 | 19.7 | 20.1 | 20.2 | 20.2 |

Based on the above results, self-tuning of the clock adjustment signal 126 from the CDR module 124 provides a SNR gain in the range of 2.0 dB and 2.5 dB.

Figure 4 shows an example of an optimization process 400 that may be implemented to tune the cut off frequency of the HPF 116 and used to obtain the results in table 2 above. The receiver 101 is initialized and the cut off frequency $f_c$ of the ADC 108 is set to an initial value at the start 402 of the initialization process 400. For the initial cut off frequency, CDR (and equalizer) of the receiver converges at 404. The estimated SNR associated with the initial cut off frequency is determined at 406. The estimated SNR from 406 is compared at 408 to a previously estimated SNR value. If the estimated SNR has improved at 408, the cut off frequency $f_c$ of the ADC is increased at 410.

The CDR (and equalizer) is determined for the new (increased) cut off frequency $f_c$ (at 404) and the estimated SNR is determined again (at 406). The cut off frequency $f_c$ is increased and the same process is repeated until the estimated SNR no longer improves during a SNR comparison stage at 408. When the estimated SNR for an increased cut off frequency $f_c$ no longer results in an improved estimated SNR at 408, the process 400 is configured to reduce (at 412) the cut off frequency $f_c$ to the value in the previous iteration. At 414 the receiver is set to use this optimised cut off frequency $f_c$ for subsequent communication with the transmitter 102.

In some examples the initial cut off frequency $f_c$ may be set to 0, in other examples the initial cut off frequency $f_c$ may be predetermined to provide a suitable initial value based on the circuit parameters as will be known to the skilled person. This can allow for reduced optimization times.

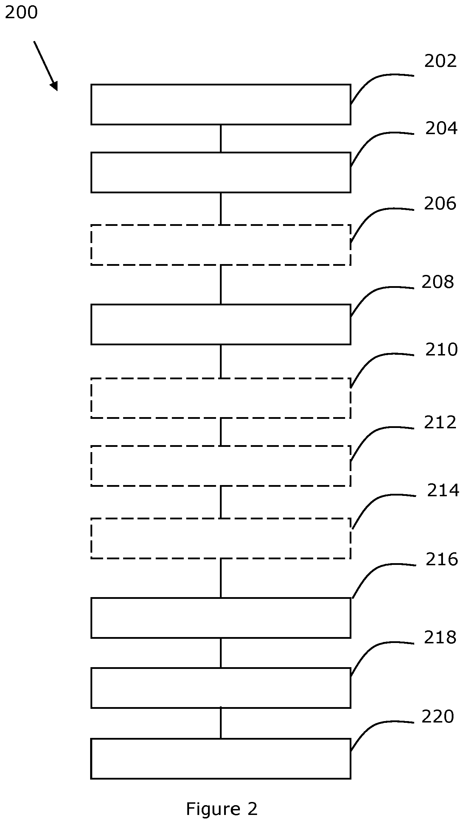

Figure 2 shows an example method 200 of controlling a receiver for a wireline channel communication system comprising:

an input for receiving a signal from one or more wires, an analog to digital converter, ADC, a slicer module, a high pass filter, HPF, a phase detector and a clock data recovery, CDR, module; the method comprising
receiving 202, by the ADC, an analog signal and converting 204 the analog signal to the digital representation of the analog signal;
assigning 208, by the slicer module, digital logic values to the digital representation of the analog signal based on an amplitude of the analog signal to form a digital logic signal;
filtering 216, by the HPF, the digital representation of the analog signal to generate a filtered signal;
determining 218, by the phase detector an error signal based on the difference between the digital logic signal and the filtered signal; and
determining 220 by the CDR module a clock adjustment signal configured to control a sampling performed by the ADC.

In some examples, the method may further comprise;

Estimating 210 a Signal to Noise Ratio based on the digital logic signal;
generating 212 a control signal based on the estimated SNR; and
tuning 214 a cut-off frequency of the HPF based on the control signal.

In some examples, the method may further comprise;

incrementing the cut off frequency of the HPF;
determining the estimated SNR;
comparing the estimated SNR to an estimated SNR for a previous cut off frequency of the HPF; wherein based on the comparison being indicative of the estimated SNR not increasing:

decrementing the cut off frequency of the HPF to the previous value of the cut off frequency; and
setting the receiver to use the decreased value of the cut off frequency as an optimised cut off frequency for further communication with the transmitter.

In some examples, the method may further comprise;
equalizing 206 the digital representation of the analog signal prior to performing the step of assigning 208, by the slicer module, of the digital logic values.

Figure 3 shows an example electronic device 300 comprising the receiver 100 of figure 1.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A receiver for a wireline channel communication system, comprising:

   an input for receiving a signal from one or more wires;
   an analog to digital converter, ADC, configured to receive an analog signal from said input and configured to output a digital representation of the analog signal;
   a slicer module configured to receive the digital representation of the analog signal and configured to output a digital logic signal based on an amplitude of the analog signal;
   a high pass filter, HPF, configured to receive the digital representation of the analog signal and output a filtered signal;
   a phase detector configured to receive a first signal based on the digital logic signal, and the filtered signal, wherein the phase detector is further configured to output an error signal indicative of a phase difference between the first signal and the filtered signal; and
   a clock data recovery, CDR, module configured to output a clock adjustment signal based on the error signal, wherein the clock adjustment signal is configured to control a sampling performed by the ADC.

2. The receiver of claim 1, further comprising a Signal to Noise, SNR, estimator, wherein the SNR estimator is configured to determine a Signal to Noise Ratio based on the digital logic signal, and wherein the HPF is a tuneable HPF, wherein a cut off frequency of the tuneable HPF is based on a control signal, wherein the control signal is based on an output of the SNR estimator.

3. The receiver of claim 1 or claim 2, further comprising an equalizer module coupled between the ADC and the slicer module, wherein the equalizer module is configured to one or more of amplify and/or attenuate specific frequency components of the digital representation of the analog signal to make the amplitude of the digital representation of the analog signal more uniform across a bandwidth of the digital representation of the analog signal.

4. The receiver of any preceding claim, wherein the slicer module is configured to compare the digital representation of the analog signal to one or more predefined thresholds and is configured to determine the digital logic signal based on the comparison.

5. The receiver of any preceding claim, wherein the phase detector comprises a Mueller-Muller phase detector.

6. The receiver of any preceding claim, wherein the input for receiving the signal from one or more wires is configured to receive the signal from a twisted pair cable.

7. The receiver of any preceding claim, wherein the tuneable HPF is provided by an Infinite Impulse Response filter.

8. The receiver of any preceding claim, wherein the tuneable HPF is a first-order HPF.

9. The receiver of any preceding claim, wherein based on the error signal, the clock adjustment signal is configured to one of

increase a time shift applied to sampling performed by the ADC in response to an increase in the error signal, or decrease a time shift applied to sampling performed by the ADC in response to a decrease in the error signal.

10. A method for controlling a receiver for a wireline channel communication system comprising:

an input for receiving a signal from one or more wires, an analog to digital converter, ADC, a slicer module, a HPF, a phase detector and a clock data recovery, CDR, module; the method comprising
receiving, by the ADC an analog signal;
converting the analog signal to a digital representation of the analog signal;
assigning, by the slicer module, digital logic values to the digital representation of the analog signal based on an amplitude of the analog signal to form a digital logic signal;
filtering, by the HPF, the digital representation of the analog signal to generate a filtered signal;
determining, by the phase detector an error signal based on the difference between the digital logic signal and the filtered signal; and
determining by the CDR module a clock adjustment signal configured to control a sampling performed by the ADC.

11. The method of claim 10, further comprising:

estimating a Signal to Noise Ratio based on the digital logic signal;
generating a control signal based on the estimated SNR; and
tuning a cut-off frequency of the HPF based on the control signal.

12. The method of claim 11, further comprising

incrementing the cut off frequency of the HPF;
determining the estimated SNR;
comparing the estimated SNR to an estimated SNR for a previous cut off frequency of the HPF; wherein based on the comparison being indicative of the estimated SNR not increasing:

decrementing the cut off frequency of the HPF to the previous value of the cut off frequency; and
setting the receiver to use the decreased value of the cut off frequency as an optimised cut off frequency for further communication with the transmitter.

13. The method of claim 10-12, further comprising:
equalizing the digital representation of the analog signal prior to performing the step of assigning, by the slicer module, of the digital logic values.

14. The method of claim 10 to 13, wherein
assigning by the slicer module, the digital logic values to the digital representation of the analog signal based on an amplitude of the analog signal to form the digital logic signal comprises:

comparing, by the slicer module, the digital representation of the analog signal to one or more predefined thresholds; and
determining the digital logic signal based on said comparison.

15. An electronic device including the receiver of claims 1 to 9.

Figure 1

200

Figure 2

300

Figure 3

400

Figure 4

## EUROPEAN SEARCH REPORT

Application Number

EP 24 21 6086

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/070031 A1 (GANESAN RAGHU [IN] ET AL) 3 March 2022 (2022-03-03)<br>* paragraph [0001] *<br>* paragraph [0028] - paragraph [0029] *<br>* paragraph [0031] - paragraph [0032] *<br>* paragraph [0034] - paragraph [0036] *<br>* paragraph [0041] *<br>* paragraph [0068] - paragraph [0070] *<br>* figures 1,8 *<br>----- | 1-15 | INV.<br>H04L7/00<br>H04L7/033<br>H04L25/03 |
| A | US 10 498 565 B1 (AZENKOT YEHUDA [US] ET AL) 3 December 2019 (2019-12-03)<br>* column 1, line 5 - line 10 *<br>* column 4, line 15 - line 65 *<br>* figure 1 *<br>----- | 1-15 | |
| A | US 10 938 604 B2 (MACOM TECH SOLUTIONS HOLDINGS INC [US]) 2 March 2021 (2021-03-02)<br>* column 4, line 11 - line 64 *<br>* figure 1 *<br>----- | 1-15 | |

**TECHNICAL FIELDS SEARCHED (IPC)**

H04L

The present search report has been drawn up for all claims

| Place of search | Date of completion of the search | Examiner |
|---|---|---|
| The Hague | 23 April 2025 | Marongiu, M |

EPO FORM 1503 03.82 (P04C01)

## ANNEX TO THE EUROPEAN SEARCH REPORT
## ON EUROPEAN PATENT APPLICATION NO.

EP 24 21 6086

This annex lists the patent family members relating to the patent documents cited in  the above-mentioned European search report.
The members are as contained in the European Patent Office EDP file on
The European Patent Office is in no way liable for these particulars which are merely given for the purpose of information.

23-04-2025

| Patent document cited in search report | | Publication date | Patent family member(s) | | Publication date |
|---|---|---|---|---|---|
| US 2022070031 | A1 | 03-03-2022 | CN | 116057889 A | 02-05-2023 |
| | | | US | 2022070031 A1 | 03-03-2022 |
| | | | US | 2023208685 A1 | 29-06-2023 |
| | | | WO | 2022051324 A1 | 10-03-2022 |
| US 10498565 | B1 | 03-12-2019 | NONE | | |
| US 10938604 | B2 | 02-03-2021 | CN | 113875200 A | 31-12-2021 |
| | | | US | 2020304352 A1 | 24-09-2020 |
| | | | US | 2022158876 A1 | 19-05-2022 |
| | | | WO | 2020191273 A1 | 24-09-2020 |

EPO FORM P0459

For more details about this annex : see Official Journal of the European Patent Office, No. 12/82